# EUROPEAN PATENT APPLICATION

(11) **EP 1 000 703 A2**
(43) Date of publication of application: **17.05.2000**
(21) Application number: 99115085.5
(22) Date of filing: 06.08.1999
(51) Int. Cl.: B24B 9/06, B24B 37/00, B24B 41/06, H01L 21/304

(54) **Edge polisher and edge polishing method**

(30) Priority: 11.11.1998 JP 32113498
(71) Applicant: SpeedFam- IPEC Co., Ltd., Ayase-shi, Kanagawa-ken (JP)
(72) Inventor: Ohnishi, Masafumi, Ayase-shi, Kanagawa-ken (JP)
(74) Representative: HOFFMANN - EITLE

(57) **Abstract**

An edge polisher and edge polishing method capable of polishing an entire edge in a state holding one side of a workpiece. In the edge polisher, a vacuum chuck (9) is used to make a silicon wafer (W) rotate in a tilted state, the silicon wafer (W) is made to move to rotating polishing drums (1) and (3) to simultaneously polish a back side inclined face of an edge portion (Wc1) and an end face of an edge portion (Wc3) by the polishing drums (1) and (3). Suitably thereafter, the silicon wafer (W) is made to move as is to rotating polishing drums (2) and (4) to simultaneously polish a front side inclined face of an edge portion (Wc2) and an end face of the edge portion (Wc4) by the polishing drums (2) and (4).

## Description

### BACKGROUND OF THE INVENTION

### 1. Field of the Invention

The present invention relates to an edge polisher and an edge polishing method for mirror surface polishing the edge of a semiconductor wafer, magnetic disk blank, or other circular workpiece.

### 2. Description of the Related Art

Silicon wafers and other semiconductor wafers are protected from chipping of their edges, protected from crowning at the time of epitaxial growth, and the like by chamfering of the edges of the wafer.

This chamfering is performed by grinding the wafer edge by a diamond grindstone, so a machining distortion layer tends to remain after grinding.

Therefore, an edge polisher has been devised to perform a mirror surface polishing the chamfered edge to remove the machining distortion layer.

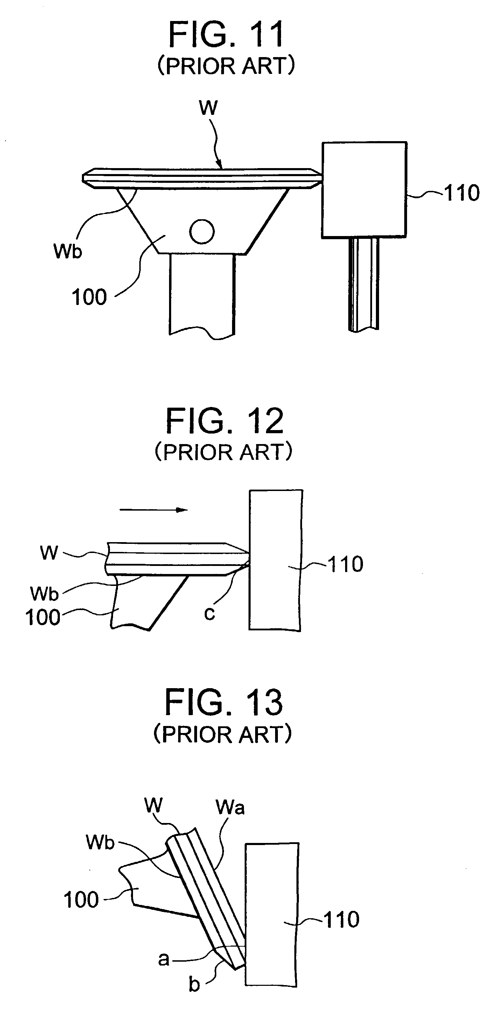

FIG. 11 is a front view of essential portions of an edge polisher according to the related art.

In FIG. 11, reference numeral 100 indicates a vacuum chuck and reference numeral 110 indicates a polishing drum.

In such an edge polisher, the back Wb of the chamfered silicon wafer W is held by the vacuum chuck 100, then, as shown in FIG. 12, the vacuum chuck 100 is made to move to the polishing drum 110 side in the state holding the silicon wafer W horizontal, and the end face c ("c") of the silicon wafer W is made to contact the rotating polishing drum 110 for polishing. Next, as shown in FIG. 13, the vacuum chuck 100 is tilted and the inclined face a ("a") of the front Wa side of the silicon wafer W is made to contact the polishing drum 110 to polish the inclined face a. Suitably thereafter, the hold by the vacuum chuck 100 is released, the silicon wafer W is turned over by a not shown robot, and the front Wa of the silicon wafer W is held by the vacuum chuck 100. Next, in the same way as shown in FIG. 13, the inclined face b ("b") of the back Wb of the silicon wafer W is polished by the polishing drum 110.

In the above edge polisher of the related art, however, there was the following problem.

In order to polish the inclined faces a and b of the silicon wafer W, it is necessary to have the front Wa and the back Wb of the silicon wafer W be alternately held by the vacuum chuck 100, so extra time is required for the operation of chucking the silicon wafer W. Further, the chucking by the vacuum chuck 100 causes contamination and damage not only on the back Wb, but also the front Wa. Therefore, in a silicon wafer W polished on its two sides, it is necessary to perform a cleaning operation for removing contamination and an operation for inspection for damage while the wafer is being moved from the edge polishing step to the next step. The work efficiency is reduced by that amount.

### SUMMARY OF THE INVENTION

The present invention was made to solve the above problem and has as its object the provision of an edge polisher and edge polishing method capable of mirror surface polishing the entire edge in the state with one side of the workpiece held.

To achieve the above object, according to a first aspect of the invention, there is provided an edge polisher comprising: a workpiece holder for holding one side of a disk-shaped workpiece having a chamfered edge and capable of rotating in a state making the workpiece tilt; a first polishing drum capable of rotating about a vertical center axis; a second polishing drum positioned on a first diametrical axial line extending out from a contact point of the first polishing drum and the workpiece through a center of the workpiece at the time of contact with the workpiece and capable of rotating about a vertical axis; and a third polishing drum positioned on a second diametrical axial line substantially perpendicular to the first diametrical axial line at the time of contact with the workpiece and capable of rotating about a vertical axis.

Due to this configuration, it is possible to polish the back side inclined face of the edge by making the workpiece rotate and bringing the back side inclined face into contact with the polishing surface of the rotating first polishing drum, in the state with the back of the workpiece held by the workpiece holder and with the workpiece tilted to an angle, whereby the back side inclined face of the edge portion at the topmost position becomes substantially vertical. Further, in the above tilted state, the edge portion on the first diametrical axial line of the workpiece becomes the bottommost position and the front side inclined face of the edge portion also becomes substantially vertical in state. Therefore, by bringing the front side inclined face into contact with the polishing surface of the rotating second polishing drum, it is possible to polish the front side inclined face of the edge as well. Further, in the tilted state, since the end face of the edge portion on the second diametrical axial line is also vertical in state, it is possible to polish the end face of the edge by bringing the end face into contact with the rotating third polishing drum. That is, in the present invention, it is possible to polish all of a chamfered edge in the state holding one side of the workpiece.

Note that it is possible to provide up to four polishing drums capable of simultaneously polishing the two inclined faces and end face of the edge of the workpiece. Therefore, according to an embodiment of the invention, there is provided an edge polisher further comprising: a fourth polishing drum positioned on the second diametrical axial line extending out from the point of contact of the third polishing drum and the workpiece through the center of the workpiece at the time of contact with the workpiece and capable of rotating about a vertical axis.

Further, according to an embodiment of the invention, there is provided an edge polisher further comprising: a movement mechanism for making the first polishing drum to fourth polishing drum move relative to the workpiece up to the contact positions.

Due to this configuration, it is possible to simultaneously or sequentially polish the two inclined faces and end face of the edge of the workpiece using the movement mechanism.

Note that the operation of the edge polisher at the time of the edge polishing stands as a process invention in its own right. Therefore, according to a second aspect of the invention, there is provided an edge polishing method comprising: a workpiece holding step for holding one side of a disk-shaped workpiece having a chamfered edge and making the workpiece rotate in a state tilted by a predetermined angle; a first polishing step for bringing a polishing surface of a first polishing drum rotating about a vertical center axis into contact with a substantially vertical inclined face of an edge portion positioned at a topmost position of the inclined workpiece for polishing; a second polishing step for bringing a polishing surface of a second polishing drum rotating about a vertical center axis into contact with a substantially vertical inclined face of an edge portion positioned at a bottommost position of the inclined workpiece for polishing; and a third polishing step for bringing a polishing surface of a third polishing drum rotating about a vertical center axis into contact with an end face of one edge portion among a pair of edge portions positioned on a diametrical axial line substantially perpendicularly intersecting a diametrical axial line passing through the topmost position and bottommost position of the workpiece for polishing.

The order of execution of the first to third polishing steps is arbitrary. Therefore, as one example, according to an embodiment of the invention, the first polishing step to third polishing step are simultaneously executed. Further, as another example, according to an embodiment of the invention, one of the first polishing step and third polishing step, the second polishing step and third polishing step, and the first polishing step and second polishing step are simultaneously executed.

Further, it is possible to provide up to four polishing drums and to simultaneously polish the two inclined faces and end face of the workpiece. Therefore, according to an embodiment of the invention, there is provided an edge polishing method further comprising: a fourth polishing step for bringing a polishing surface of a fourth polishing drum rotating about a vertical center axis into contact with an end face of the other edge portion among the pair of edge portions for polishing.

Further, the order of execution of the first to fourth polishing steps is arbitrary. Therefore, an one example, according to an embodiment of the invention, the first polishing step to fourth polishing step are simultaneously executed. Further, as another example, according to an embodiment of the invention, one of a process of simultaneously executing the first polishing step and third polishing step, then simultaneously executing the second polishing step and fourth polishing step; a process of simultaneously executing the second polishing step and third polishing step, then simultaneously executing the first polishing step and fourth polishing step; and a process of simultaneously executing the first polishing step and second polishing step, then simultaneously executing the third polishing step and fourth polishing step.

### BRIEF DESCRIPTION OF THE DRAWINGS

The above and other objects, features, and advantages of the present invention will become more readily apparent from the following detailed description of presently preferred embodiments of the invention taken in conjunction with the accompanying drawings, in which:
FIG. 1 is a schematic plan view of an edge polisher according to a first embodiment of the present invention;
FIG. 2 is a schematic sectional view of the edge polisher shown in FIG. 1;
FIG. 3 is a front view of a chamfered silicon wafer;
FIG. 4 is a schematic sectional view of a chuck body;
FIG. 5 is a schematic plan view of the positional relationship of contact of polishing drums and a silicon water;
FIG. 6 is a sectional view along the line A-A of FIG. 1 showing the state of simultaneous execution of first and third polishing steps;
FIG. 7 is a sectional view along the line A-A of FIG. 1 showing the state of simultaneous execution of second and fourth polishing steps;
FIG. 8 is a schematic plan view of an edge polisher according to a second embodiment of the present invention;
FIG. 9 is a sectional view along the line C-C of FIG. 8;
FIG. 10 is a sectional view along the line D-D of FIG. 8;
FIG. 11 is a schematic front view of the essential portions of an edge polisher according to the related art;
FIG. 12 is a partial enlarged view of the state of polishing of the end face of a silicon wafer; and
FIG. 13 is a partial enlarged view of the state of polishing of an inclined face of the silicon wafer.

### DESCRIPTION OF THE PREFERRED EMBODIMENTS

Preferred embodiments of the present invention will be explained next with reference to the drawings.

### (First Embodiment)

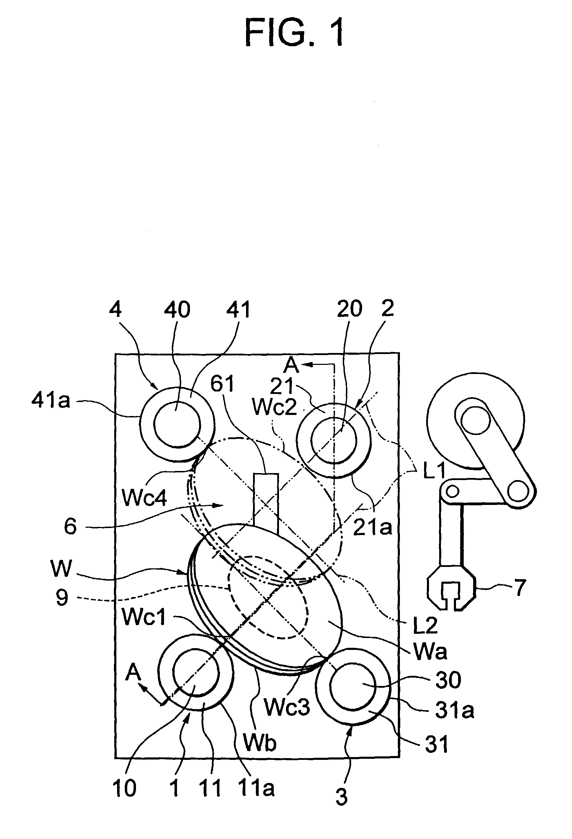

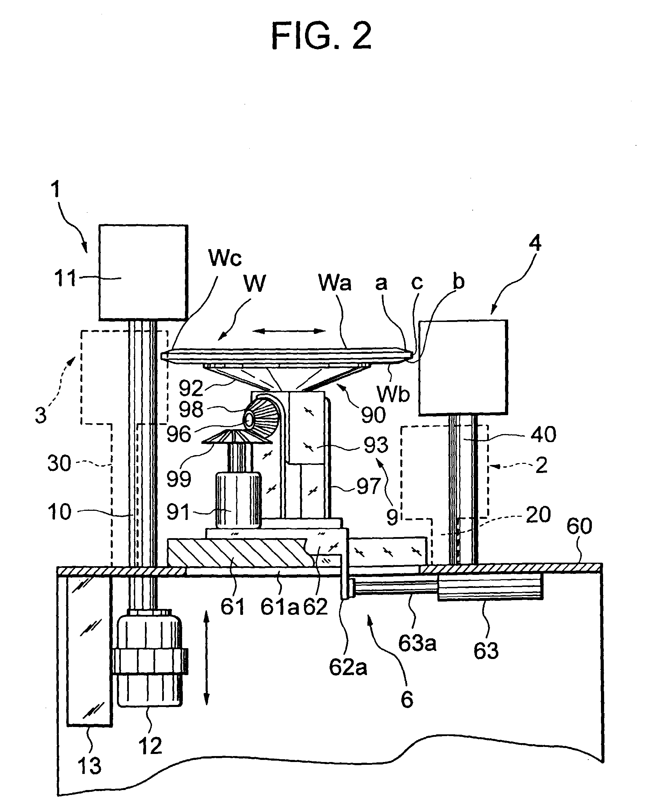

FIG. 1 is a schematic plan view of an edge polisher according to a first embodiment of the present invention, while FIG. 2 is a schematic sectional view.

As shown in FIG. 1, this edge polisher is comprised of a vacuum chuck 9 serving as a workpiece holder, a polishing drum 1 serving as a first polishing drum, a polishing drum 2 serving as a second polishing drum, a polishing drum 3 serving as a third polishing drum, a polishing drum 4 serving as a fourth polishing drum, and a movement mechanism 6.

The vacuum chuck 9 is a device which holds one side of a silicon wafer W as an example of a disk-shaped workpiece having a chamfered edge and enables the silicon wafer W to be rotated in a tilted state.

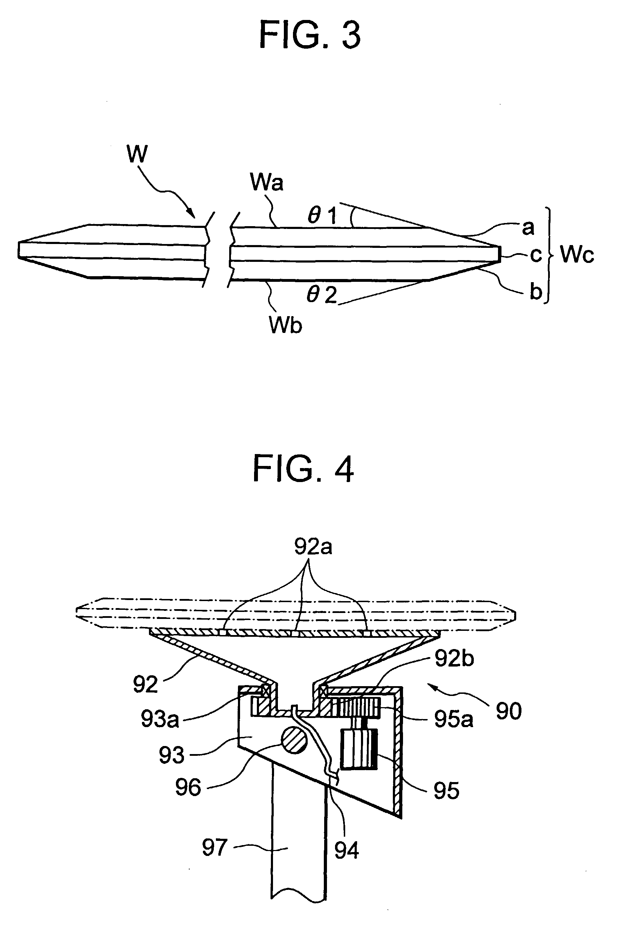

FIG. 3 is a front view of a silicon wafer W chamfered in a previous step and held by the vacuum chuck 9.

As shown in FIG. 3, the edge Wc of the silicon wafer W is chamfered. The edge Wc is formed with an inclined face a ("a") at the front Wa side, an inclined face b ("b") at the back Wb side, and an end face c ("c"). Further, the chamfer angle .1 of the inclined face a and the chamfer angle .2 of the inclined face b are set to be substantially equal.

The vacuum chuck 9, as shown in FIG. 2, is comprised of a chuck body 90 and a motor 91 for tilting the chuck body 90.

FIG. 4 is a schematic sectional view of the chuck body 90.

The chuck body 90 is constructed with a hollow wafer suction member 92 having a flat surface with a plurality of suction holes 92a rotatably attached to a holder 93 through a bearing 93a. Due to this, it is possible to use a not shown vacuum pump to draw out the air inside the wafer suction member 92 through a tube 94 and hold the silicon wafer W placed on the surface by suction.

The wafer suction member 92 is provided with a gear 92b. This gear 92b engages with a gear 95a of a motor 95 affixed to the holder 93. Due to this, by operating the motor 95, the rotational force is transmitted through the gears 95a, 92b to the wafer suction member 92 and the silicon wafer W rotates.

The holder 93 rotatably holding such a wafer suction member 92 is affixed to a shaft 96 rotatably attached to a support plate 97.

The shaft 96, as shown in FIG. 2, has a bevel gear 98 attached to it. The bevel gear 98 engages with a bevel gear 99 attached to a shaft of the motor 91. Due to this, by operating the motor 91, it is possible to make the chuck body 90 tilt by a desired angle about the shaft 96.

The movement mechanism 6 is a mechanism for making the polishing drums 1 to 4 move relative to the silicon wafer W up to positions of contact with the silicon wafer W. Here, it is structured to make the vacuum chuck 9 move to the polishing drums 1 and 3 or make it move to the polishing drums 2 and 4.

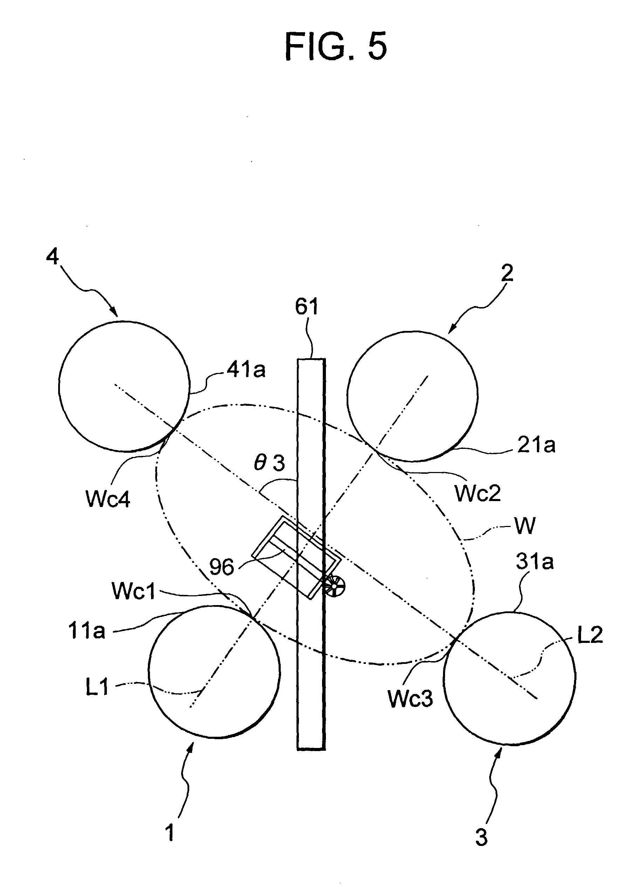

Specifically, a rail 61 is laid on the base 60 and a slider 62 is placed slidably on the rail 61. Further, as shown in FIG. 5, the vacuum chuck 9 is attached to the slider 62 so that the shaft 96 is inclined by exactly an angle .3 with respect to the rail 61. Further, a coupling portion 62a is formed at the bottom of the slider 62. The coupling portion 62a hangs through a pair of elongated holes 60a formed in the base 60 down to the back of the base 60. Further, the front end of a piston rod 63a of an air cylinder 63 is connected to this coupling portion 62a. Due to this, by operating the air cylinder 63, it is possible to make the vacuum chuck 9 as a whole move on the rail 61 in the lateral direction in FIG. 2.

The polishing drum 1 is a columnar body for polishing the back Wb side inclined face b (see FIG. 3) of the edge Wc of the silicon wafer W. As shown in FIG. 2, it is constructed with a polishing pad 11 attached to the top of a vertical rotational shaft 10. Further, the bottom of the shaft 10 is connected to a motor 12. The motor 12 is designed to be held by an elevator 13 and raised or lowered vertically.

The polishing drum 1, as shown in FIG. 1, is arranged to the bottom left of the rail 61 and, as shown in FIG. 5, is arranged at a position able to contact the edge Wc1 of the silicon wafer W on a first diametrical axial line L1 perpendicularly intersecting the axial line of the shaft 96.

Further, in FIG. 1, the polishing drum 2 is a columnar body for polishing the front Wa side inclined face a (see FIG. 3) of the edge Wc of the silicon wafer W and is constructed the same as the polishing drum 1. That is, as shown in FIG. 2, it is constructed with a polishing pad 21 attached to the top of a vertical rotational shaft 20 and with the bottom of the shaft 20 connected to a motor able to be raised or lowered vertically by a not shown elevator.

The polishing drum 2 is arranged to the top right of the rail 61 and, as shown in FIG. 5, is arranged at a position able to contact the edge Wc2 on the silicon wafer W on the first diametrical axial line L1 facing the edge Wc1.

Further, the polishing drums 3, 4 are columnar bodies for polishing the end face c (see FIG. 3) of the edge Wc of the silicon wafer W and are constructed the same as the polishing drums 1, 2. That is, they are constructed with polishing pads 31, 41 attached to the tops of vertical shaft 30, 40 and with the bottoms of the shafts 30, 40 connected to motors able to be raised or lowered vertically by not shown elevators.

The polishing drums 3, 4 are arranged to the bottom right and top left of the rail 61, respectively, and, as shown in FIG. 5, are arranged at positions able to contact the edges Wc3, Wc4 on the axial line of the shaft 96, that is, a diametrical axial line L2 perpendicularly intersecting the first diametrical axial line L1 of the silicon wafer W, respectively.

Due to the positional relationship of the polishing drums 1 to 4, as shown in FIG. 1, the quadrilateral connecting the centers of the drums forms a parallelogram. The length of the diagonal line is set to be slightly larger than the diameter of the silicon wafer W so that contact between the horizontal state silicon wafer W held on the vacuum chuck 9 and the shafts 10 to 40 of the polishing drums 1 to 4 is avoided.

Note that reference numeral 7 is a robot for loading and unloading silicon wafers W to and from the wafer suction member 92 of the vacuum chuck 9.

Next, an explanation will be given of the operation of the edge polisher of this embodiment.

Note that the edge polisher, when operated, specifically realizes the edge polishing method according to the present invention.

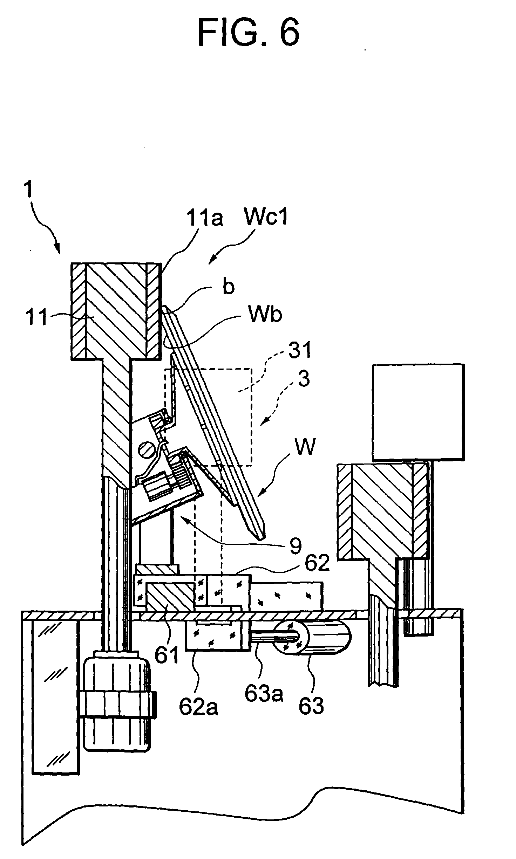

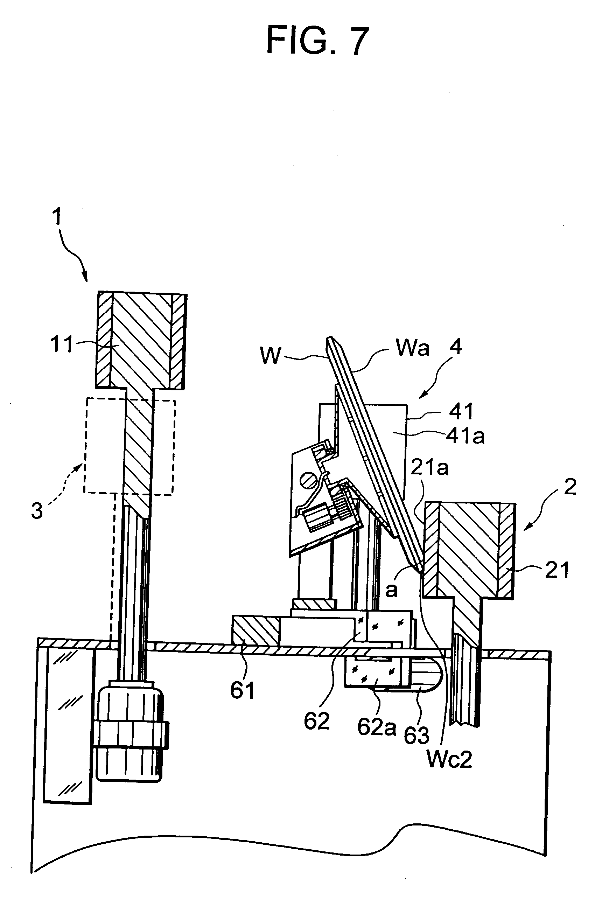

FIG. 6 is a sectional view along the line A-A of FIG. 1 showing the state of simultaneous execution of first and third polishing steps, while FIG. 7 is a sectional view along the line A-A of FIG. 1 showing the state of simultaneous execution of second and fourth polishing steps.

First, the wafer holding step is executed.

As shown in FIG. 2, the vacuum chuck 9 is positioned at substantially the center of the rail 61 and the wafer suction member 92 of the vacuum chuck 9 is made horizontal. In this state, the silicon wafer W is carried by a robot 7 (see FIG. 1) to the wafer suction member 92 and placed on the wafer suction member 92 with the back Wb facing down. Suitably thereafter, the air inside the wafer suction member 92 is drawn out to hold the silicon wafer W on the wafer suction member 92 from the back Wb side and keep it horizontal. The motor 91 is then operated to make the chuck body 90 tilt and make the silicon wafer W tilt so that the back Wb side inclined face b of the edge portion Wc1 positioned at the topmost position becomes substantially parallel to the polishing surface 11a of the polishing pad 11 of the polishing drum 1. Suitably thereafter, the motor 95 (see FIG. 3) is operated to make the silicon wafer W rotate at a predetermined speed.

In parallel with this step, the motor 12 etc. are used to make the polishing drums 1 to 4 rotate in directions opposite to the direction of rotation of the silicon wafer W.

Next, the first polishing step and the third polishing step are simultaneously executed.

That is, the vacuum chuck 9 holding the inclined silicon wafer W is made to move to the left side in FIG. 2 by the movement mechanism 6. Specifically, the air cylinder 63 is operated to extend the piston rod 63a, whereby the slider 62 is made to slide on the rail 61 to the left side. Next, as shown in FIG. 6, the movement of the vacuum chuck 9 is made to stop in the state with the silicon wafer W made to contact the polishing drum 1.

Due to this, as shown in FIG. 1, FIG. 5, and FIG. 6, the back Wb side inclined face b of the edge portion Wc1 on the diametrical axial line L1 positioned at the topmost position of the silicon wafer W abuts against the polishing surface 11a of the polishing pad 11 and the end face c of the edge portion Wc3 on the diametrical axial line L2 abuts against the polishing surface of the polishing pad 31 of the polishing drum 3. Threfore, the inclined face b and end face c are simultaneously polished by the polishing drum 1 and the polishing drum 3.

After the simultaneous execution of the above first polishing step and third polishing step is completed, the second polishing step and fourth polishing step are simultaneously executed.

That is, the air cylinder 63 of the movement mechanism 6 is operated to retract the piston rod 63a and thereby make the slider 62 slide on the rail 61 to the right side of FIG. 2 and make the vacuum chuck 9 holding the tilted silicon wafer W move to the right side. Next, as shown in FIG. 7, the movement of the vacuum chuck 9 is made to stop when the silicon wafer W contacts the polishing drum 2.

Due to this, as shown in FIG. 1, FIG. 5, and FIG. 7, the front Wa side inclined face a of the edge portion Wc2 on the diametrical axial line L1 positioned at the bottommost position of the silicon wafer W abuts against the polishing surface 21a of the polishing pad 21 and the end face c of the edge portion Wc4 on the diametrical axial line L2 abuts against the polishing surface 41a of the polishing pad 41 of the polishing drum 4. Therefore, the inclined face a and end face c are simultaneously polished by the polishing drum 2 and the polishing drum 4.

After the end of the above steps, the vacuum state in the wafer vacuum holder 92 of the vacuum chuck 9 is released and the robot 7 can be used to unload the silicon wafer W from the vacuum chuck 9 and transfer it to a not shown cleaning step or inspection step.

In this way, according to the edge polisher of this embodiment, since it is possible to polish all of the inclined faces a and b and the end face c of the edge Wc in the state with the back Wb of the silicon wafer W held by the vacuum chuck 9, there is no work of turning over the silicon wafer W for polishing the inclined face a after polishing the inclined face b of the edge Wc, and therefore the labor involved in the edge polishing work can be reduced and the time shortened by that amount. Further, since the only surface held by the vacuum chuck 9 is the back Wb, it is enough to perform the operation for cleaning off contamination and/or the operation for inspection for damage at just the back Wb and as a result the efficiency of work can be improved.

### (Second Embodiment)

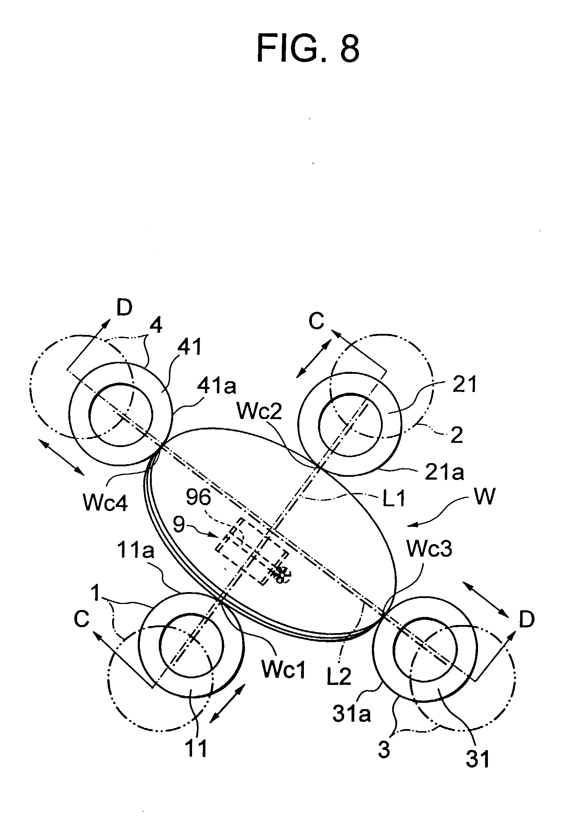

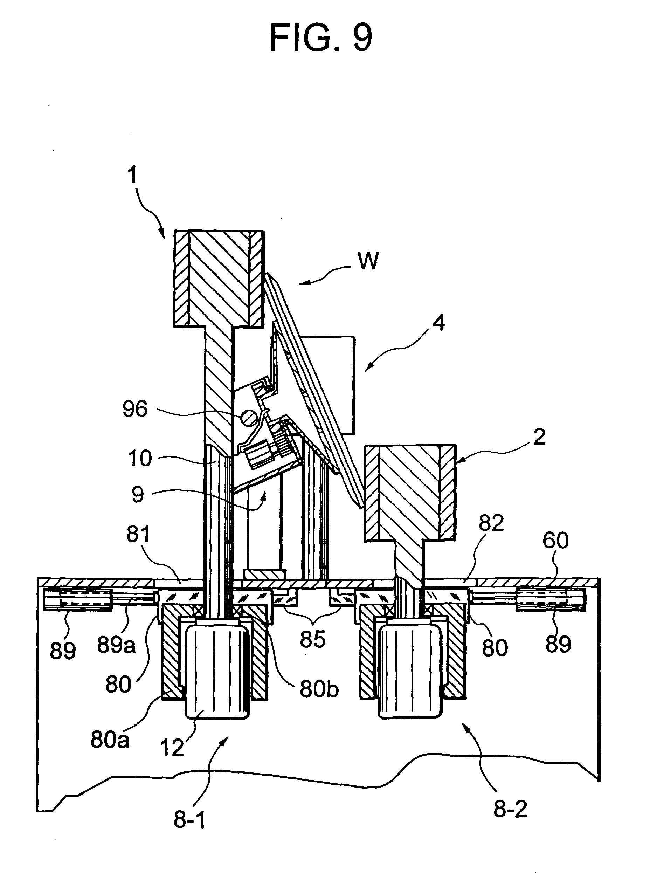

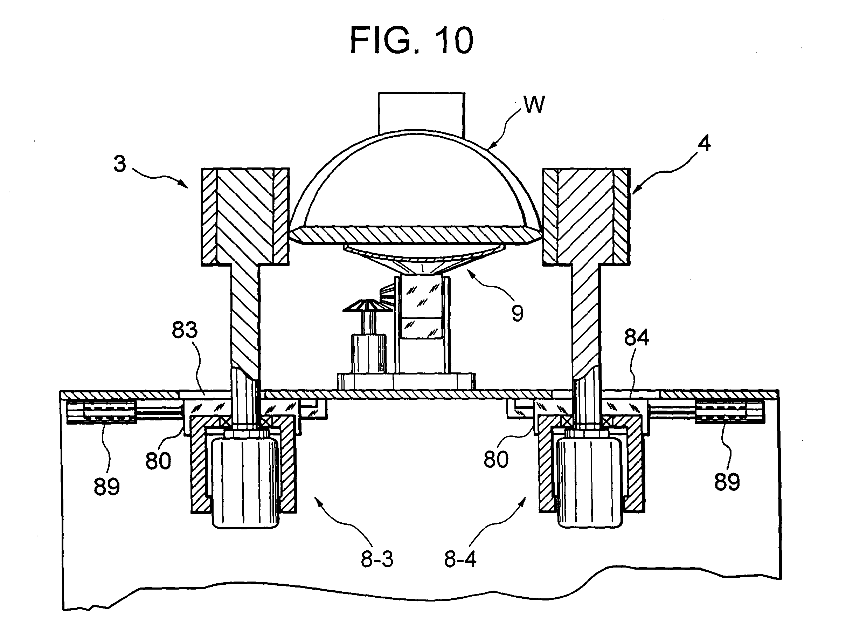

FIG. 8 is a plan view of an edge polisher according to a second embodiment of the present invention, FIG. 9 is a sectional view along the line C-C of FIG. 8, and FIG. 10 is a sectional view along the line D-D of FIG. 8. Note that members the same as members shown in FIG. 1 to FIG. 7 are explained with the same reference numerals.

The edge polisher of this embodiment differs from the first embodiment in the point that it is constructed to enable the inclined faces a and b and the end face c of the edge Wc of the silicon wafer W to be simultaneously polished.

As shown in FIG. 8 to FIG. 10, the vacuum chuck 9 is affixed to the base 60. The shaft 96, in the same way as the first embodiment, is tilted by exactly an angle of .3 with respect to the diametrical axial line L1 of the silicon wafer W.

Further, as shown in FIG. 9 and FIG. 10, movement mechanisms 8-1 to 8-4 are provided below the base 60 to make the polishing drums 1 to 4 move to positions contacting the silicon wafer W.

The movement mechanism 8-1 for making the polishing drum 1 move, as shown in FIG. 9, is comprised of a slider 80 for holding the motor 12 of the polishing drum 1 and an air cylinder 89 for making the slider 80 slide. Specifically, an elongated hole 81 is formed in the base 60 along the diametrical axial line L1 and the rail 85 is attached in parallel to the elongated hole 81 at the bottom side of the base 60. Further, the slider 80 is attached slidably to the rail 85, while the motor 12 is held at a holder 80a formed projecting from the side surface of the slider 80. Further, the shaft 10 connected to the motor 12 passes through the elongated hole 81 and extends upward from the base 60 in the state rotatably supported by the bearings 80b. In this way, the front end of the piston rod 89a of the air cylinder 89 positioned at the left side of FIG. 9 is connected to the slider 80 holding the motor 12.

Due to this, by operating the air cylinder 89 to extend and retract the piston rod 89a, the slider 80 can be made to slide laterally along the rail 85 and move the polishing drum 1 to approach the silicon wafer w from the left side or pull back from it.

The movement mechanism 8-2 for making the polishing drum 2 move is structured the same as the movement mechanism 8-1, but the elongated hole 82 formed along the diametrical axial line L1 is positioned at the right side of the silicon wafer W.

Due to this, by operating the air cylinder 89, it is possible to make the polishing drum 2 approach the silicon wafer W from the right side or pull back from it.

Further, the movement mechanisms 8-3 and 8-4 for moving the polishing drums 3 and 4, as shown in FIG. 10, are substantially the same as the movement mechanisms 8-1 and 8-2 in structure, but the elongated hole 83 of the movement mechanism 8-3 for the polishing drum 3 and the elongated hole 84 of the movement mechanism 8-4 for the polishing drum 4 are formed along the diametrical axial line L2 and face each other across the silicon wafer W.

Due to this, by operating the air cylinders 89, it is possible to make the polishing drum 3 approach the silicon wafer W from the left side of FIG. 10 or pull back from it and possible to make the polishing drum 4 approach the silicon wafer W from the right side or pull back from it.

Next, the operation of the edge polisher of this embodiment will be explained.

Note that the edge polisher, when operated, specifically realizes the edge polishing method according to the present invention.

First, the wafer holding step is executed.

That is, as shown by the two-dot chain line of FIG. 8, the silicon wafer W held by the vacuum chuck 9 is tilted and made to rotate at a predetermined speed in the state with the polishing drums 1 to 4 pulled back from the silicon wafer W.

Next, the first polishing step to the fourth polishing step are simultaneously executed.

That is, the air cylinders 89 (see FIG. 9 and FIG. 10) are operated to extend the piston rods 89a to make the polishing drums 1 to 4 move to the silicon wafer W side in the state with the polishing drums 1 to 4 made to rotate. If this is done, the polishing surface 11a of the polishing pad 11 of the polishing drum 1 contacts the inclined face b of the edge portion Wc1 of the silicon wafer W (see FIG. 3), while the polishing surface 21a of the polishing pad 21 of the polishing drum 2 contacts the inclined face a of the edge portion Wc2. Further, the polishing surfaces 31a and 41a of the polishing drums 3 and 4 contact the end faces c of the edge portions Wc3 and Wc4, respectively. By making the polishing drums 1 to 4 stop moving in this state, it is possible to simultaneously polish the inclined faces a and b and the inclined face c of the edge Wc of the silicon wafer W.

In this way, according to the edge polisher of this embodiment, since it is possible to simultaneously polish the inclined faces a and b and end face c of the edge Wc of the silicon wafer W, it is possible to shorten the time of the edge polishing work. Further, since the polishing drums 1 to 4 support the silicon wafer W by four points, it is possible to prevent the silicon wafer W from shifting etc. and as a result possible to achieve stable polishing.

The rest of the configuration, mode of operation, and advantageous effects are similar to those of the above first embodiment, so descriptions thereof will be omitted.

Note that the present invention is not limited to the above embodiments. Various modifications and changes are possible within the range of the gist of the invention.

In the first embodiment, the first polishing step and third polishing step were executed simultaneously, then the second polishing step and fourth polishing step were executed simultaneously, but of course it is also possible to execute the second polishing step and the fourth polishing step simultaneously, then execute the first polishing step and third polishing step simultaneously.

Further, in the second embodiment, an example was shown of simultaneous execution of the first polishing step to fourth polishing step, but it is also possible to successively execute the first to fourth polishing steps in consideration of the work conditions and also possible to simultaneously execute the second polishing step and third polishing step, then simultaneously execute the first polishing step and fourth polishing step or simultaneously execute the first polishing step and second polishing step, then simultaneously execute the third polishing step and fourth polishing step.

As explained above in detail, according to the present invention, since it is possible to polish the entire surface of the chamfered edge while holding one side of the workpiece, it is not necessary to turn over and reset the workpiece like with the edge polisher of the related art. Therefore, there is the superior effect of enabling the work time to be shortened by that amount. Further, since only one side of the workpiece is held, the side not held by the workpiece holder will not be contaminated or damaged. As a result, there is the effect that the work for cleaning to remove the contamination and the work of inspection for damage while the workpiece is being moved from the polishing step to the next step are halved and therefore the work efficiency is improved by that amount.

## Claims

1. An edge polisher comprising:
a workpiece holder for holding one side of a disk-shaped workpiece having a chamfered edge and capable of rotating in a state making the workpiece tilt;
a first polishing drum capable of rotating about a vertical center axis;
a second polishing drum positioned on a first diametrical axial line extending out from a contact point of said first polishing drum and the workpiece through a center of the workpiece at the time of contact with the workpiece and capable of rotating about a vertical axis; and
a third polishing drum positioned on a second diametrical axial line substantially perpendicular to said first diametrical axial line at the time of contact with the workpiece and capable of rotating about a vertical axis.

2. An edge polisher as set forth in claim 1, further comprising: a fourth polishing drum positioned on the second diametrical axial line extending out from the point of contact of said third polishing drum and the workpiece through the center of the workpiece at the time of contact with the workpiece and capable of rotating about a vertical axis.

3. An edge polisher as set forth in claim 1, further comprising: a movement mechanism for making said first polishing drum to fourth polishing drum move relative to the workpiece up to the contact positions.

4. An edge polishing method comprising:
a workpiece holding step for holding one side of a disk-shaped workpiece having a chamfered edge and making the workpiece rotate in a state tilted by a predetermined angle;
a first polishing step for bringing a polishing surface of a first polishing drum rotating about a vertical center axis into contact with a substantially vertical inclined face of an edge portion positioned at a topmost position of the inclined workpiece for polishing;
a second polishing step for bringing a polishing surface of a second polishing drum rotating about a vertical center axis into contact with a substantially vertical inclined face of an edge portion positioned at a bottommost position of the inclined workpiece for polishing; and
a third polishing step for bringing a polishing surface of a third polishing drum rotating about a vertical center axis into contact with an end face of one edge portion among a pair of edge portions positioned on a diametrical axial line substantially perpendicularly intersecting a diametrical axial line passing through the topmost position and bottommost position of the workpiece for polishing.

5. An edge polishing method as set forth in claim 4, wherein said first polishing step to third polishing step are simultaneously executed.

6. An edge polishing method as set forth in claim 4, wherein one of said first polishing step and third polishing step, said second polishing step and third polishing step, and said first polishing step and second polishing step are simultaneously executed.

7. An edge polishing method as set forth in claim 4, further comprising: a fourth polishing step for bringing a polishing surface of a fourth polishing drum rotating about a vertical center axis into contact with an end face of the other edge portion among the pair of edge portions for polishing.

8. An edge polishing method as set forth in claim 7, wherein said first polishing step to fourth polishing step are simultaneously executed.

9. An edge polishing method as set forth in claim 7, wherein one of a process of simultaneously executing said first polishing step and third polishing step, then simultaneously executing said second polishing step and fourth polishing step; a process of simultaneously executing said second polishing step and third polishing step, then simultaneously executing said first polishing step and fourth polishing step; and a process of simultaneously executing said first polishing step and second polishing step, then simultaneously executing said third polishing step and fourth polishing step.
